(19) Europäisches Patentamt
European Patent Office
Office européen des brevets

(11) **EP 4 588 892 A1**

(12) **EUROPEAN PATENT APPLICATION**
published in accordance with Art. 153(4) EPC

(43) Date of publication:
**23.07.2025 Bulletin 2025/30**

(21) Application number: **22958873.6**

(22) Date of filing: **30.09.2022**

(51) International Patent Classification (IPC):
**C01B 32/15** (2017.01)   **C09K 11/65** (2006.01)
**B82Y 5/00** (2011.01)   **B82Y 40/00** (2011.01)

(52) Cooperative Patent Classification (CPC):
**C01B 32/15; C09K 11/65; B82Y 5/00; B82Y 30/00; B82Y 40/00**

(86) International application number:
**PCT/JP2022/036803**

(87) International publication number:
**WO 2024/057555 (21.03.2024 Gazette 2024/12)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **14.09.2022  PCT/JP2022/034481**

(71) Applicant: **M. Technique Co., Ltd.**
**Izumi-shi, Osaka 594-1144 (JP)**

(72) Inventors:
• **OHKAWA Hideki**
**Izumi-shi, Osaka 594-1144 (JP)**
• **ENOMURA Masakazu**
**Izumi-shi, Osaka 594-1144 (JP)**

(74) Representative: **Marks & Clerk LLP**
**15 Fetter Lane**
**London EC4A 1BW (GB)**

(54) **SINGLE-CRYSTAL SPHERICAL CARBON NANOPARTICLE PRODUCTION METHOD**

(57)     The present application is related to a method of producing single-crystal spherical carbon nanoparticles that are single-crystals and spherical. The single-crystal spherical carbon nanoparticles produced by the production method of the present invention can generate fluorescence with high fluorescence quantum efficiency when excited by a light in a wide wavelength range from ultraviolet light to visible light, and have a fluorescence quantum efficiency of 10% or more compared to conventionally known carbon nanoparticles. In addition, The single-crystal spherical carbon nanoparticles produced by the production method of the present invention can be used for drug delivery, because they do not have toxicities to living organisms that compound semiconductors made of cadmium, selenium, tellurium, etc. have. Furthermore, since the single-crystal spherical carbon nanoparticles produced by the production method of the present invention are spherical, they can be densely packed as electrode materials for solar cells and secondary ion batteries, and can be used for a negative electrode for lithium batteries or an electrode material for solar cells.

FIG. 2

EP 4 588 892 A1

## Description

### TECHNICAL FIELD

The present inventions relate to a method of producing single-crystal spherical carbon nanoparticles.

### BACKGROUND ART

Carbon nanoparticles are nanoparticles made of carbon atoms. Carbon nanoparticles with a particle diameter of less than 10 nm are also called carbon quantum dots. Quantum dots that are formed from metal elements such as CdSe and CdTe and exhibit fluorescence are known as quantum dots. However, these quantum dots are not suitable for use within the human body. Thus, efforts have been made to find alternative materials.

It is known that carbon nanoparticles can be produced by a top-down or bottom-up method. As a top-down method of producing carbon nanoparticles, known are, for example, a method of producing carbon nanoparticles from at least micron-sized carbon materials such as graphite, carbon nanotubes and diamonds, using a laser ablation, arc discharge, or electrochemical method. On the other hand, as a bottom-up method of producing carbon nanoparticles, known are, for example, a method of heat-treating pure water or an organic solvent under a high temperature and high pressure condition known as a hydrothermal method, and a chemical vapor deposition method (CVD).

When carbon nanoparticles are used for drug delivery within a human body, it is necessary to treat hydrophobic carbon nanoparticles to make them hydrophilic. For that purpose, an oxidation reaction under the air atmosphere is performed, or after a surfactant is mixed and dispersed in an aqueous solution, surface of the carbon nanoparticle is subjected to a hydrophilic treatment using an oxidation agent or the like. Such hydrophilic treatment of carbon nanoparticles in an aqueous solution combined with surface activation requires a cleaning process to remove the surfactant after the treatment, and such complicated treatment has been a problem.

Claim 1 of Patent Literature 1 describes a carbon nanoparticle phosphor containing carbon atoms, oxygen atoms, nitrogen atoms, and optionally hydrogen atoms. Because of the C-N bond and the C-O bond, the carbon nanoparticle phosphor can be dispersed in an aqueous solution. Claim 9 of Patent Literature 1 describes that the carbon nanoparticle phosphor is produced by a method including a step of hydrothermal synthesis of a solution in which an organic substance selected from the group consisting of citric acid, benzoic acid, glucose, fructose and sucrose; and an amine; and one or more selected from inorganic acids and acetic acid are dissolved in a water-soluble solvent. The spatial lattice, which is structural information of the carbon nanoparticle phosphor, is not disclosed.

Patent Literature 2 describes a carbon composite for an oxygen reduction catalyst comprising nanosheet-like graphene oxide or its reduced product and carbon quantum dots (Claim 1). Patent Literature 2 describes that carbon quantum dots may be carbon obtained by a conventional hydrothermal reaction, for example, carbon obtained by heating an aqueous solution containing a carbon source compound such as citric acid and a nitrogen source compound such as ethylenediamine at a temperature higher than the boiling point of water (Claim 6, [0031], etc.). These carbon quantum dots are different from the single-crystal spherical carbon nanoparticles produced by the production method of the present invention, and Patent Literature 2 does not describe that the carbon composite is single-crystal and spherical.

Patent Literature 3 describes a method of producing luminescent nanocarbon comprising a reaction step of reacting a raw material solution containing a carbon source compound and a nitrogen source compound by a solvothermal synthesis method or the like (Claim 1, [0013]). This luminescent nanocarbon is produced by hydrothermal synthesis similar to the production method of Patent Literature 1, and Patent Literature 3 does not describe that the luminescent nanocarbon is single-crystal and spherical.

Patent Literature 4 describes a method of forming carbon dots, comprising: (a) mixing carbon powders with sulfuric acid and nitric acid to form a carbon powder mixture; (b) heating the carbon powder mixture under reflux to form a refluxed carbon powder mixture; (c) cooling the refluxed carbon powder mixture; and (d) neutralizing the refluxed carbon powder mixture to form a neutralized carbon powder containing solubilized carbon dots (Claim 1, [0036]). By using acid in this step (a), the carbon powders are oxidized to a quantum size of 1.5 to 6 nm ([0037], [0038]). The carbon dots prepared by the above formation method have abundant carboxyl groups on their surface and may have negative charges on the carboxyl groups ([0048]). The carbon dots are different from the single-crystal spherical carbon nanoparticles produced by the production method of the present invention because they have abundant carboxyl groups on their surface. Further, Patent Literature 4 does not disclose that the carbon dots are is single-crystals and spherical.

Patent Literature 5, filed by the applicant of the present application, describes a method of producing semiconductor microparticles using a fluid processing apparatus equipped with relatively rotating processing surfaces that can approach and separate (Claim 1). Patent Literature 5 describes that specific examples of the semiconductor element are an element selected from the group consisting of silicon, germanium, carbon and tin ([0037]). However, Patent Literature 5 does not describe specific examples in which the semiconductor element is carbon. Even based on Patent Literature 5, single-crystal spherical carbon nanoparticles could not be obtained.

Patent Literature 6, filed by the applicant of the present application, describes a method of producing crystals made of fullerene using a fluid processing apparatus equipped with relatively rotating processing surfaces that can approach and separate (Claim 1). This production method uses already prepared fullerene as a raw material and recrystallizes it, and the production method is not a method of producing fullerene itself. As mentioned above, Patent Literature 6 does not describe that the crystals are single-crystals and spherical.

Non-Patent Literature 1 describes that amine-terminated carbon quantum dots were obtained by reducing carbon tetrachloride with a hydride reduction agent such as lithium aluminum hydride to obtain carbon quantum dots, and then reacting with an arylamine in the presence of a platinum catalyst. Since the carbon quantum dots of Non-Patent Document 1 have $NH_2$ groups on their surface, they are different from the single-crystal spherical carbon nanoparticles produced by the production method of the present invention. Furthermore, Non-Patent Literature 1 does not describe that the amine-terminated carbon quantum dots are single-crystals and spherical.

CITATION LIST

PATENT LITERATURE

Patent Literature 1: WO 2018/163955
Patent Literature 2: JP 2019-155349
Patent Literature 3: JP 2021-183548
Patent Literature 4: JP 2019-511442
Patent Literature 5: JP 4458202
Patent Literature 6: JP 4363495

NON-PATENT LITERATURE

Non Patent Literature 1: Journal of Materials Chemistry, Volume 2, pp. 6025-6031 (2014)

SUMMARY OF THE INVENTION

TECHNICAL PROBLEM

The problem of the present invention is to provide a method of producing carbon nanoparticles that can produce blue to red fluorescence upon excitation wavelengths ranging from ultraviolet light to visible light, and can be used as a fluorescent marker that can be injected into living organisms as drug delivery with almost no toxicities, and can be filled at high density as electrode materials for secondary batteries.

SOLUTION TO THE PROBLEM

As a result of intensive studies to solve the above problems, the present inventors have found that single-crystal spherical carbon nanoparticles that are single-crystals and spherical, could be produced by preparing an anion of a condensed aromatic compound by mixing lithium, sodium or potassium with the condensed aromatic compound at a temperature below 0°C, and mixing and reacting a raw material liquid containing carbon halide with a reduction liquid containing the prepared anion of the condensed aromatic compound. The produced single-crystal spherical carbon nanoparticles are single-crystals without grain boundaries reducing luminous efficiency, so they can produce high fluorescence quantum efficiencies when excited by light with a wide range of wavelengths from ultraviolet light to visible light. They can be also used as a fluorescent marker for drug delivery. They can be also densely packed as electrode materials for solar cells and secondary ion batteries. The present invention was completed based on the above discovery.

Namely, the present inventions are as follows.

[1] A method of producing single-crystal spherical carbon nanoparticles that are single-crystals and are spherical, comprising a step of mixing and reacting a raw material liquid containing halogenated carbon and a reduction liquid containing an anion of a condensed aromatic compound produced from lithium, sodium or potassium and the condensed aromatic compound, wherein the anion of the condensed aromatic compound is obtained by mixing lithium, sodium or potassium with the condensed aromatic compound at a temperature below 0°C.

[2] The method according to [1], wherein an average value of a circularity calculated by the formula: $4\pi S/Z^2$ is 0.9 or more, when using the perimeter (Z) and the area (S) of the projected image of the single-crystal spherical carbon nanoparticle observed by a transmission electron microscope.

[3] The method according to [1] or [2], wherein the average particle diameter is 1 nm to 30 nm.

[4] The method according to any one of [1] to [3], wherein the raw material liquid and the reduction liquid are mixed and reacted with each other using an apparatus, and

wherein the apparatus comprises a fluid pressure imparting mechanism for imparting a predetermined pressure to fluids to be processed; at least two processing members of a first processing member and a second processing member, the second processing member being capable of approaching to and separating from the first processing member; and a rotation drive mechanism for rotating the first processing member and the second processing member relative to each other; and

wherein the at least two processing members provide at least two processing surfaces of a first processing surface and a second processing surface disposed in a position facing with each other,

each of the processing surfaces constitute part of a sealed flow path through which the fluid to be processed under the predetermined pressure is passed,

the processing surfaces are for mixing and reacting two or more fluids to be processed, at least one of which contains a reactant, with each other,

of the first and second processing members, at least the second processing member is provided with a pressure-receiving surface, and at least part of the pressure-receiving surface is comprised of the second processing surface,

the pressure-receiving surface receives pressure applied to the fluids to be processed by the fluid pressure imparting mechanism and thereby generates a force to move in the direction of separating the second processing surface from the first processing surface,

the fluids to be processed under the predetermined pressure are passed between the first and second processing surfaces being capable of approaching to and separating from each other, at least one of which rotates relative to the other, whereby the fluids to be processed form a thin film fluid while passing between the first and second processing surfaces,

the apparatus further comprises an introduction path independent of the flow paths through which the fluids to be processed under the predetermined pressure are passed; and at least one opening leading to the introduction path and being arranged in at least either the first processing surface or the second processing surface, and

at least one of the fluids to be processed is sent from the introduction path and introduced into between the first and second processing surfaces, and a reactant contained at least in any one of the aforementioned fluids to be processed is mixed with the fluids to be processed other than the fluid containing the reactant in the thin film fluid.

[5] The method according to [4], wherein the opening is located downstream of a point at which the flow of the fluids to be processed that is passed between the two processing surfaces becomes a laminar flow.

[6] The method according to any one of [1] to [5], wherein the molar ratio of the lithium, sodium or potassium and the halogenated carbon is 7:1 to 4:1.

[7] The method according to any one of [1] to [6], wherein the condensed aromatic compound is at least one selected from the group consisting of biphenyl, naphthalene, 1,2-dihydronaphthalene, anthracene, phenanthrene and pyrene.

[8] The method according to [7], wherein when the condensed aromatic compound is biphenyl, naphthalene or anthracene, an IR absorption spectrum of the reduction liquid shows an absorption peak in the wave number range of $1200 \text{ cm}^{-1}$ to $1100 \text{ cm}^{-1}$.

[9] The method according to any one of [1] to [8], wherein the solvent contained in the reduction liquid is tetrahydrofuran and/or dimethoxyethane with residual water of 10 ppm or less.

[10] The method according to any one of [1] to [9], wherein the solvent contained in the reduction liquid is tetrahydrofuran which contains a phenolic polymerization inhibitor, and has residual water of 10 ppm or less and residual oxygen concentration of less than 0.1 ppm.

[11] The method according to any one of [1] to [10], wherein the solvent contained in the raw material liquid is tetrahydrofuran which has residual water of 10 ppm or less and a residual oxygen concentration of less than 0.1 ppm.

[12] The method according to any one of [1] to [11], wherein the halogenated carbon is carbon tetrachloride, carbon tetrabromide, or carbon tetraiodide.

[13] The method according to any one of [1] to [12], wherein the single-crystal spherical carbon nanoparticles are hexagonal and the spatial lattice is a simple lattice, a rhombohedral lattice, or a combination of a simple lattice and a rhombohedral lattice.

[14] The method according to any one of [1] to [13], wherein the single-crystal spherical carbon nanoparticles have an absorption peak in the wavenumber range of $2800 \text{ cm}^{-1}$ to $2950 \text{ cm}^{-1}$ in an IR absorption spectrum, and the area of the absorption peak of $1000 \text{ cm}^{-1}$ to $1100 \text{ cm}^{-1}$ obtained by waveform separation of the wavenumber range of $900 \text{ cm}^{-1}$ to $1900 \text{ cm}^{-1}$ is 15% or less of the total area of absorption peaks in the wavenumber range of $900 \text{ cm}^{-1}$ to $1900 \text{ cm}^{-1}$.

[15] The method according to any one of [1] to [14], wherein in an IR absorption spectrum of the single-crystal spherical carbon nanoparticles, the area of the absorption peak of 1300 $cm^{-1}$ to 1400 $cm^{-1}$ obtained by waveform separation of the wavenumber range of 900 $cm^{-1}$ to 1900 $cm^{-1}$ is 10% or less of the total area of absorption peaks in the wavenumber range of 900 $cm^{-1}$ to 1900 $cm^{-1}$.

[16] The method according to any one of [1] to [15], wherein in a Raman scattering spectrum of the single-crystal spherical carbon nanoparticles, the ratio of $I_D/I_G$ is 1.0 or less, wherein $I_G$ is the intensity of the peak from 1550 $cm^{-1}$ to 1650 $cm^{-1}$, and $I_D$ is the intensity of the peak from 1250 $cm^{-1}$ to 1350 $cm^{-1}$.

[17] The method according to any one of [1] to [16], wherein the single-crystal spherical carbon nanoparticles have a fluorescence maximum in a wavelength range of 400 nm to 600 nm in a fluorescence spectrum.

ADVANTAGEOUS EFFECTS OF THE INVENTION

The production method of the present invention, enables to produce the single-crystal spherical carbon nanoparticles that are single-crystals and spherical. The produced single-crystal spherical carbon nanoparticles produced by the production method of the present invention are single-crystals without grain boundaries reducing fluorescence efficiency, so that they can generate fluorescence with high fluorescence quantum efficiency when excited by a light in a wide wavelength range from ultraviolet light to visible light, and can increase a fluorescence quantum efficiency up to 10% or more compared to conventionally known carbon nanoparticles. In addition, the single-crystal spherical carbon nanoparticles produced by the production method of the present invention can be used for drug delivery, because they do not have toxicities to living organisms that compound semiconductors made of cadmium, selenium, tellurium, etc. have. Furthermore, since the single-crystal spherical carbon nanoparticles produced by the production method of the present invention are spherical, they can be densely packed as electrode materials for solar cells and secondary ion batteries, and can be used for a negative electrode for lithium batteries or an electrode material for solar cells.

BRIEF DESCRIPTION OF THE DRAWINGS

FIG. 1 shows an IR absorption spectrum of naphthalene anion in the single-crystal spherical carbon nanoparticle reduction liquid.

FIG. 2 shows a TEM observation image of the single-crystal spherical carbon nanoparticles produced in Example 1-1.

FIG. 3 shows an IR spectrum of the single-crystal spherical carbon nanoparticles produced in Example 1-2 at the wavenumber of 2700 $cm^{-1}$ to 3050 $cm^{-1}$.

FIG. 4 shows waveform separation of the IR spectrum of the single-crystal spherical carbon nanoparticles produced in Example 1-2 at the wavenumbers 900 $cm^{-1}$ to 1900 $cm^{-1}$.

FIG. 5 shows a normalized fluorescence spectrum of the single-crystal spherical carbon nanoparticles produced in Example 1-3, that is, the normalized fluorescence spectrum with the maximum intensity set to 1.0 and the excitation wavelength varied from 300 nm to 750 nm in steps of 40 nm.

FIG. 6 shows a diagram showing the relationship between excitation wavelength and fluorescence peak wavelength, prepared based on the results of FIG. 5. FIG. 6 indicates dependency of excitation wavelength to fluorescence peak wavelength of the single-crystal spherical carbon nanoparticles of Example 1-3.

FIG. 7 shows a Raman scattering spectrum of the single-crystal spherical carbon nanoparticles produced in Example 1-3 at a wave number of 1250 $cm^{-1}$ to 1700 $cm^{-1}$.

FIG. 8 shows X-ray diffraction patterns of the single-crystal spherical carbon nanoparticles produced in Examples 1-1 to 1-3 at diffraction angles ($2\theta$) of 42° to 46°.

FIG. 9 shows X-ray diffraction patterns of the single-crystal spherical carbon nanoparticles produced in Examples 3-1 to 3-3 at diffraction angles ($2\theta$) of 42° to 46°.

FIG. 10 shows a normalized fluorescence spectrum of the single-crystal spherical carbon nanoparticles produced in Example 3-3, that is, the normalized fluorescence spectrum with the maximum intensity set to 1.0 and the excitation wavelength varied from 240 nm to 360 nm.

DESCRIPTION OF THE INVENTION

Hereinafter, embodiments of the present invention will be described. However, the present invention is not limited to the embodiments described below. Further, an exemplary application thereof to a light emitting material that emits fluorescence will be described, but the applications of the single-crystal spherical carbon nanoparticles produced by the production method of the present invention are not limited thereto.

## 1. Single-crystal spherical carbon nanoparticles

The single-crystal spherical carbon nanoparticles produced by the production method of the present invention are single-crystals and spherical. The average particle diameter of the single-crystal spherical carbon nanoparticles is preferably 1 nm to 30 nm. In case of the average particle diameter of 30 nm or more, when using the single-crystal spherical carbon nanoparticles as a negative electrode material for a secondary battery, it is difficult to achieve packing at high density. The single-crystal spherical carbon nanoparticles are hexagonal. This hexagonal space lattice can have a simple lattice structure or a rhombohedral lattice structure. The single-crystal spherical carbon nanoparticles are spherical, and may be approximately spherical. The average value of circularity of the single-crystal spherical carbon nanoparticles is preferably 0.9 or more, more preferably 0.92 or more, still more preferably 0.95 or more. The average value of circularity is calculated using the formula: $4\pi S/Z^2$ using the perimeter (Z) and area (S) of a projected image of the single-crystal spherical carbon nanoparticle observed by a transmission electron microscope. When attempting to utilize fluorescence from the single-crystal spherical carbon nanoparticles, the average particle diameter of the single-crystal spherical carbon nanoparticles is preferably 1.2 nm to 10 nm, more preferably 1.5 nm to 7 nm, more preferably 2 nm to 5 nm.

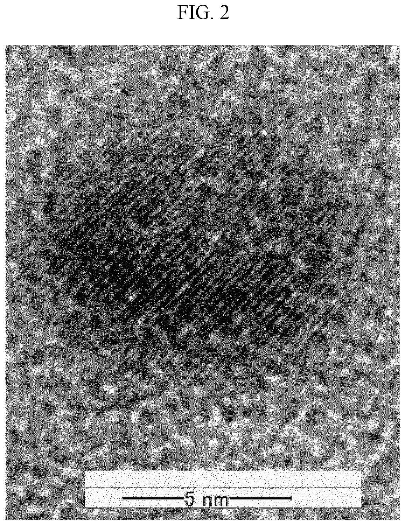

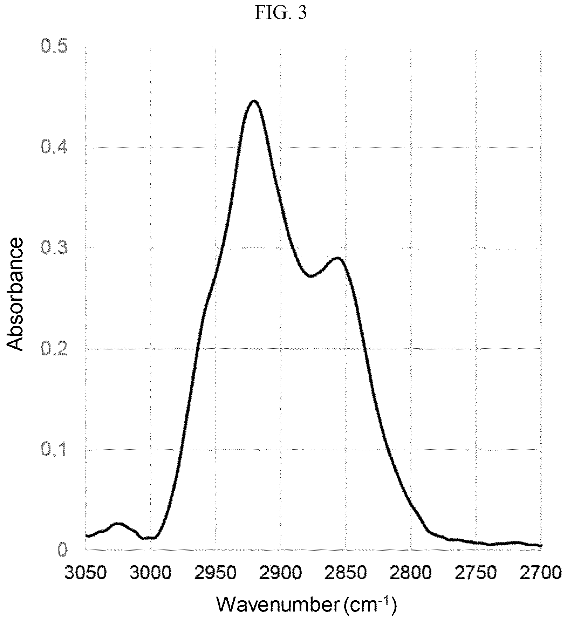

It is known that carbon has various structures, including graphene layers based on C=C bonds consisting of carbon atoms with sp2 hybrid orbital, graphite in which the graphene layers are stacked in the c-axis direction, and carbon nanotube structure. However, since these structures do not have a band gap, the excited electrons generated by the excitation light and the holes which are electron vacancies left by the excited electrons, immediately recombine and do not generate fluorescence. For this reason, it is necessary to generate a band gap in carbon made of carbon atoms with sp2 hybrid orbital by some method. One of methods for this purpose is to cut the bonding region of carbon atoms with sp2 hybrid orbital in the graphene layer, and to introduce bonds of carbon atoms with sp3 hybrid orbital by bonding the carbon atoms to carbon atoms or elements other than carbon atoms. The bond of carbon atoms with sp3 hybrid orbital can generate C-H bonds or C-O bonds by bonding hydrogen or oxygen to the edges of the graphene layer. Therefore, preferable is the carbon nanoparticles having a stacked structure of graphene layers in which C-H bonds are present inside the graphene layer constituting the single-crystal spherical carbon nanoparticles and C-O bonds are present at the edge of the graphene layer. The presence of C-O bonds in the single-crystal spherical carbon nanoparticles can be confirmed, for example, by the presence of absorption in the wavenumber range of 2800 cm$^{-1}$ to 2950 cm$^{-1}$ in the IR absorption spectrum attributed to stretching vibrations of C-H bond, and absorption in the wavenumber range of 1000 cm$^{-1}$ to 1100 cm$^{-1}$ attributed to the stretching vibrations of C-O bond. As shown in FIG. 2 and FIG. 3, the single-crystal spherical carbon nanoparticles of Example 1-2 has absorption peaks of C-H bond at 2925 cm$^{-1}$ and 2852 cm$^{-1}$ and an absorption peak of C-O bond at 1097 cm$^{-1}$. Accordingly, the structural change that contributes to the generation of a band gap due to the presence of a carbon atom with sp3 hybrid orbital, can be confirmed.

The single-crystal spherical carbon nanoparticles preferably exhibit an absorption peak in the wavenumber range of 2800 cm$^{-1}$ to 2950 cm$^{-1}$ in the IR absorption spectrum. An area of the absorption peak of the single-crystal spherical carbon nanoparticles in 1000 cm$^{-1}$ to 1100 cm$^{-1}$ (stretching vibration of C-O bond) obtained by waveform separation of the wavenumber range of 900 cm$^{-1}$ to 1900 cm$^{-1}$ is preferably 15% or less (ratio of C-O bond), more preferably 2% or more and 15% or less, even more preferably 2% or more and 10% or less, and even further more preferably 2% or more and 8.5% or less of the total area of absorption peaks in the wavenumber range of 900 cm$^{-1}$ to 1900 cm$^{-1}$.

A ratio of $I_D / I_G$ of the single-crystal spherical carbon nanoparticles is preferably 1.0 or less, more preferably 0.95 or less, even more preferably 0.85 or less, even further more preferably 0.65 or less, even much more preferably 0.55 or less. In the ratio, $I_G$ is the intensity of the peak from 1650 cm$^{-1}$ to 1550 cm$^{-1}$ and $I_D$ is the intensity of the peak from 1250 cm$^{-1}$ to 1350 cm$^{-1}$ in the Raman scattering spectrum.

The single-crystal spherical carbon nanoparticles are preferably single-crystal spherical carbon nanoparticles that exhibit a fluorescence maximum in the wavelength range of 400 nm to 600 nm in the fluorescence spectrum.

An area of the absorption peak of the single-crystal spherical carbon nanoparticles in 1300 cm$^{-1}$ to 1400 cm$^{-1}$ obtained by waveform separation of the wavenumber range of 900 cm$^{-1}$ to 1900 cm$^{-1}$ is preferably 10% or less (ratio of C-N bond), more preferably 8% or less, even more preferably 6.5% or less of the total area of absorption peaks in the wavenumber range of 900 cm$^{-1}$ to 1900 cm$^{-1}$.

It is known that fluorescence of carbon nanoparticles occurs by three different mechanisms below.

(A) Control of fluorescence color by controlling a physical factor of changing the band gap of electron energy according to the particle diameter of carbon nanoparticles into which carbon atoms with sp3 hybrid orbital are introduced (known as quantum effect).

(B) Control of fluorescence color via surface substituents in a state where a various substituent such as an alkyl group with a different molecular chain length and an amino group is chemically bonded to the surface of carbon nanoparticles by surface modification of treating the carbon nanoparticles with a various chemical.

(C) Control of fluorescent color by a chemical factor by utilizing a compositional change mediated by oxygen or nitrogen contained in carbon nanoparticles.

In the single-crystal spherical carbon nanoparticles of the present invention, (A) quantum effect mechanism and (C) oxygen mediated mechanism of the three mechanisms (A) to (C) act synergistically to produce fluorescence. This is different from the mechanism of the amino group-terminated carbon nanoparticles of Non Patent Literature 1, which use (A) quantum effect mechanism and (B) surface modification mechanism. The single-crystal spherical carbon nanoparticles of the present invention preferably exhibit a fluorescence maximum in the wavelength range of 400 nm to 600 nm.

2. Method of producing single-crystal spherical carbon nanoparticles

The production method of the present invention is a method of producing the single-crystal spherical carbon nanoparticles that are single-crystals and spherical. The production method comprises a step of mixing and reacting a raw material liquid containing a carbon halide with a reduction liquid containing an anion of a condensed aromatic compound generated from lithium, sodium or potassium and the condensed aromatic compound, wherein the anion of the condensed aromatic compound is obtained by mixing lithium, sodium or potassium with the condensed aromatic compound at a temperature below 0°C. For example, the single-crystal spherical carbon nanoparticles can be produced by mixing a liquid containing a raw material of the single-crystal spherical carbon nanoparticles (Liquid B) with a reduction liquid containing metal lithium and a condensed aromatic compound (Liquid A) in a thin film fluid formed between two processing surfaces that are arranged opposite to each other and can approach and separate, at least one of which rotates relative to the other.

(Single-crystal spherical carbon nanoparticle raw material liquid (Liquid B))

The raw material of the single-crystal spherical carbon nanoparticles is not particularly limited as long as it is a substance capable of precipitating the single-crystal spherical carbon nanoparticles by reduction. For example, the raw material may be preferably carbon tetrahalide, more preferably carbon tetrachloride, carbon tetrabromide, carbon tetraiodide, and the like. and even more preferably carbon tetrachloride, carbon tetrabromide, and the like.
A solvent of the single-crystal spherical carbon nanoparticle raw material liquid is not particularly limited as long as it can precipitate the single-crystal spherical carbon nanoparticles by reducing the raw material of the single-crystal spherical carbon nanoparticles and it is a substance which is inert and does not affect the reduction reaction. Preferably, the solvent includes an ether, and the like, and more preferably tetrahydrofuran (THF), dioxane, 1,2-dimethoxyethane (DME), diethylene glycol dimethyl ether, diethylene glycol diethyl ether, diethyl ether, polyethylene glycol dimethyl ether, and a mixture thereof, and the like, and even more preferably THF, DME and the like.

(Residual water / residual oxygen in solvent)

It is preferable to use a solvent in which the residual water in the solvent used in the present invention is 10 ppm or less. The reason is that when the single-crystal spherical carbon nanoparticles are produced by a reduction reaction in a solvent, if the residual water is more than 10 ppm, the oxidation reaction of the graphene layer becomes significant, and causes distortion in the graphite structure generated by stacking the graphene layers in the c-axis direction. Further, when the graphene layers cannot be stacked on each other, there will be an inconvenience that the single-crystal spherical carbon nanoparticles will not be formed.
The residual oxygen concentration in the solvent used in the present invention is preferably less than 0.1 ppm.

(Single-crystal spherical carbon nanoparticle reduction liquid (Liquid A))

A reduction agent contained in the single-crystal spherical carbon nanoparticle reduction liquid is not particularly limited as long as it can precipitate the single-crystal spherical carbon nanoparticles by reducing a raw material of the single-crystal spherical carbon nanoparticles contained in the single-crystal spherical carbon nanoparticle raw material liquid. Examples of the reduction agent include, for example, a combination of metal lithium and a condensed aromatic compound.
Examples of the condensed aromatic compound include those that can receive one electron from metal lithium to produce a lithium ion and a condensed aromatic compound anion (radical anion). The condensed aromatic compound anion with one electron transferred has one electron in the lowest unoccupied molecular orbital (LUMO) of the condensed aromatic compound. For example, when the raw material of the single-crystal spherical carbon nanoparticles is carbon tetrahalide, the potential of the condensed aromatic compound anion needs to be less than -1.9 V in order to reduce carbon tetrahalide to carbon nanoparticles, because the reduction potential of carbon tetrachloride is -1.9 V. Here, the potential is a value relative to silver (Ag) / silver chloride (AgCl) as a standard electrode (reference electrode). Examples of condensed aromatic compounds whose potential is less than -1.9V, include naphthalene (-2.53V), DBB (-2.87V), biphenyl (-2.68V), 1,2-dihydronaphthalene (-2 .57V), phenanthrene (-2.49V), anthracene (-2.04V), pyrene (-2.13V), and a mixture thereof, preferably naphthalene, DBB, biphenyl, and the like. On the other hand, tetracene (-1.55V) and azulene (-1.62V) are not suitable for reducing carbon tetrachloride.

Examples of the molar ratio of metal lithium and the condensed aromatic compound include 1:1 to 1:5, preferably 1:1 to 1:1.2, and more preferably 1:1 to 1:15.

Examples of the molar ratio of metal lithium and the raw material of the single-crystal spherical carbon nanoparticles include 10:1 to 1.2:1, preferably 7:1 to 1.5:1, more preferably 5:1 to 3:1. It is preferable to use metal lithium in excess of the raw material of the single-crystal spherical carbon nanoparticles. By using an excessive amount of metal lithium, the single-crystal spherical carbon nanoparticles can be produced. When using metal lithium in an amount smaller than that of the raw material of the single-crystal spherical carbon nanoparticles, for example, when using metal lithium in an amount of 3/4 of the amount of the raw material, the raw material would not be completely reduced, so that halogen atoms derived from the raw material remain in the single-crystal spherical carbon nanoparticles, and the resulting carbon nanoparticles become polycrystalline and not spherical. Examples of the solvent of the single-crystal spherical carbon nanoparticle reduction liquid include the above solvent used in the single-crystal spherical carbon nanoparticle raw material liquid. The concentration of metal lithium in the solvent of the single-crystal spherical carbon nanoparticle reduction liquid is not particularly limited, but is determined according to the molar ratio of metal lithium to the raw material of the single-crystal spherical carbon nanoparticles described above.

(Low-temperature preparation of reduction liquid)

Alkali metal can be dissolved in an ether-based organic solvent in the coexistence of a condensed aromatic compound. However, if the dissolution temperature is 0°C or higher, there is a problem that the condensed aromatic compound anion becomes unstable, and a chemical reaction between the condensed aromatic compound and the alkali metal atom occurs, and the effectiveness of the reduction liquid is impaired. For example, when naphthalene (molecular formula: $C_{10}H_8$) is used as a condensed aromatic compound and lithium (Li) is used as an alkali metal, there is a problem that there was a tendency that a compound such as $C_{10}H_7Li$ is generated, causing a change of the concentration of naphthalene anion that act as a reduction agent. For this reason, in the production method of the present invention, the preparation temperature at the stage of preparing the single-crystal spherical carbon nanoparticles reduction liquid is maintained below 0°C, so that the condensed aromatic compound anion can stably exist, and the decomposition of the condensed aromatic compound anion can be suppressed.

(Solvent molecule intervened alkali metal cation and condensed aromatic compound anion)

It is possible to bond by Coulomb force the condensed aromatic compound anion produced by the electron transfer of metal lithium to the condensed aromatic compound to the metal lithium cation produced by the electron transfer. There is a concern of change of the reduction power due to reverse electron transfer from the once generated condensed aromatic compound anion to lithium cation. Fluctuations in the reduction power affect the particle diameter distribution of the resulting single-crystal spherical carbon nanoparticles. Therefore, in order to suppress fluctuations in the reduction power due to reverse electron transfer, it is possible for lithium cation and the condensed aromatic compound anion to have a bonding state through solvent molecules based on the Coulomb force. It is known that such bonding state of an anion and a cation in a solution can be confirmed by measuring ultraviolet-visible absorption spectrum. According to the measurement, it is known that in case of a combination of metal lithium and naphthalene which are dissolved in tetrahydrofuran of an ether-based organic solvent, the bonding state of intervention of THF at 25°C exists at 60% to 80%; and in case of a combination of metal sodium and naphthalene which are dissolved in THF, sodium cation and the naphthalene anion are directly bonded by Coulombic force almost without intervention of THF.

(Solvation in low-temperature preparation)

Intervention of a solvent is possible by keeping the temperature of the solvent low. In other words, intervention of a solvent means that a solvated cation and a solvated anion exist wherein the lithium cation and the condensed aromatic compound anion are each surrounded by solvent molecules, and the two solvents are in contact with each other. Since such solvent can intervene and create a state that the cation and anion are in contact with each other in the solution, the condensed aromatic compound anion can exist stably, and reverse electron transfer from the condensed aromatic compound anion to the lithium cation can be suppressed. Even if a reduction liquid prepared in the state of insufficient solvation by preparation of a reduction liquid at a temperature of 0°C or higher or the state of existence of distribution in solvation state, is cooled to a low temperature during the preparation of the carbon nanoparticles, solvation does not necessarily occur completely, causing variations in the reduction power and a distribution of the particle diameter of the carbon nanoparticles in the solution. In an equilibrium state where ions are directly bonded to each other by Coulomb force at a low temperature, even if the liquid is cooled to a low temperature during the preparation of the carbon nanoparticles, the solvent molecules cannot overcome the Coulomb force and enter between the cation and anion. Therefore, the temperature during liquid preparation is important.

(Suppression of polymerization of solvent)

The necessity of preparing the reduction liquid at low temperature is as described above from the viewpoint of solvation. In addition to that, the storage temperature after the liquid preparation should also be kept low. This is because when the storage temperature of the reduction liquid is high and a cyclic ether such as THF is used as a solvent, a reductive polymerization reaction of THF, etc. is caused by the condensed aromatic compound anions. Since such polymerization product generated due to the polymerization of the cyclic ether such as THF will be included in the single-crystal spherical carbon nanoparticles produced by reduction of carbon halide, it is necessary to suppress the polymerization reaction. Examples of a THF polymerization reaction inhibitor include a phenol-based polymerization inhibitor added to suppress production of a peroxide of the cyclic ethers such as THF, preferably BHT (2,6-di-tert-butyl-4-methylphenol).

(Method of producing single-crystal spherical carbon nanoparticles: Apparatus)

The single-crystal spherical carbon nanoparticles of the present invention can be produced, for example, by mixing a liquid containing a raw material of the single-crystal spherical carbon nanoparticles (Liquid B) with a reduction liquid containing metal lithium and a condensed aromatic compound (Liquid A) in a thin film fluid formed between two processing surfaces arranged opposite each other, which are capable of approaching and separating, and at least one of which rotates relative to the other.

Examples of the apparatus used in the production method of the present invention include a fluid processing apparatus as proposed by the present applicant and described in JP 2009-112892. The apparatus comprises a stirring tank having an inner peripheral surface which cross-section is circular, and a mixing tool attached to the stirring tank with a slight gap to the inner peripheral surface of the stirring tank, wherein the stirring tank comprises at least two fluid inlets and at least one fluid outlet; from one of the fluid inlets, the first fluid to be processed containing one of the reactants among the fluids to be processed is introduced into the stirring tank; from one fluid inlet other than the above inlet, the second fluid to be processed containing one of reactants different from the above reactant is introduced into the stirring tank through a different flow path. At least one of the stirring tank and the mixing tool rotates at a high speed relative to the other to let the above fluids be in a state of a thin film; and in the above thin film, the reactants contained in the first and second fluids to be processed are reacted. Examples of the apparatus also include an apparatus based on the same principle as the fluid processing apparatus described in Patent Literatures 6 and 7.

Preferably, the single-crystal spherical carbon nanoparticles are produced by mixing the liquid containing a raw material of the single-crystal spherical carbon nanoparticles (Liquid B) and the above reduction liquid (Liquid A) in the thin film fluid. The single-crystal spherical carbon nanoparticles are produced in two steps in which at first, a graphene layer as a core of the single-crystal spherical carbon nanoparticle is generated, and then the single-crystal spherical carbon nanoparticles are grown by stacking them on top of each other. Even if Liquid B comes into contact with Liquid A at a temperature of less than 5°C and the reaction starts, since the frequency of generation of the core for growth of the single-crystal spherical carbon nanoparticles is set low, the frequency of contact between the cores of the single-crystal spherical carbon nanoparticles is also decreased. For this reason, the growth of the single-crystal spherical carbon nanoparticles is less susceptible to changes in the concentration of the raw material liquid due to the growth of surrounding single-crystal spherical carbon nanoparticles, and the supply of the raw material necessary for the growth of the single-crystal spherical carbon nanoparticles can be uniform.

Examples of the temperature of the single-crystal spherical carbon nanoparticle reduction liquid (Liquid A), which is introduced into a thin film fluid formed between two processing surfaces arranged to be opposite to each other to be able to approach to and separate from each other, at least one of which rotates relative to the other, include a temperature of -30°C to 25°C, preferably -10°C to 25°C, and more preferably 0°C to 25°C. In Examples 1 and 3, as a result of the production carried out with Liquid A at 17°C, single-crystal spherical carbon nanoparticles that are single-crystals and spherical and produce fluorescence at a high fluorescence quantum efficiency could be produced.

Examples of the temperature of the single-crystal spherical carbon nanoparticle raw material liquid (Liquid B), which is introduced into a thin film fluid formed between two processing surfaces arranged to be opposite to each other to be able to approach to and separate from each other, at least one of which rotates relative to the other, include a temperature of -10°C to 25°C, preferably 0°C to 25°C, and more preferably 10°C to 25°C. In Examples 1 to 3, as a result of the production carried out with Liquid B at 23°C, single-crystal spherical carbon nanoparticles that are single-crystals and spherical and produce fluorescence at a high fluorescence quantum efficiency could be produced.

In the production of the single-crystal spherical carbon nanoparticles, for example, lithium chloride is produced as a by-product. Since lithium chloride has high solubility in the reaction solvent, it can be easily separated from the single-crystal spherical carbon nanoparticles by centrifugation.

3. Application of single-crystal spherical carbon nanoparticles

The single-crystal spherical carbon nanoparticles produced by the production method of the present invention can be used, for example, in a light-emitting element, a luminescent material that produce fluorescence, a negative electrode of a lithium ion battery, an electrode material for a solar cell, and a bonding material for a semiconductor device to other substrates, etc.

EXAMPLE

Hereinafter, the present invention is explained in more detail with reference to Examples, but the present invention is not limited only to these Examples.

(Transmission electron microscope (TEM): Preparation of sample for TEM observation)

The single-crystal spherical carbon nanoparticles obtained in Examples and Comparative Examples were dispersed in THF at a concentration of approximately 0.001% in a vessel. The vessel containing the obtained dispersion liquid was introduced into a glove box under an argon atmosphere, and the dispersion liquid was dropped onto a carbon support membrane and dried to obtain a sample for TEM observation.

(TEM Observation)

A transmission electron microscope JEM-2100 (JEOL Ltd.) was used for TEM observation of the single-crystal spherical carbon nanoparticles. The above sample for TEM observation was used as a sample. The observation condition was an accelerating voltage of 200 kV and an observation magnification of 10,000 times or more. The particle diameter was calculated from the distance between the maximum outer circumferences of the single-crystal spherical carbon nanoparticles observed by TEM, and the average value (average particle diameter) of the results of measuring the diameters of the 50 single-crystal spherical carbon nanoparticles was calculated.

(Infrared (IR) absorption spectrum)

The IR absorption spectrum of the single-crystal spherical carbon nanoparticles was measured using the Fourier transform infrared spectrophotometer FT/IR-6600 (JASCO Corporation) by Attenuated total reflection (ATR) method. The measurement condition was the resolution of 4.0 cm$^{-1}$, accumulated number of 128 times, diamond prism (PKS-D1F) (wide area): refractive index of 2.4) incorporated in ATR PRO 470-H, which is an accessory of FT/IR-6600, and the incident angle of 45°. An infrared (IR) absorption spectrum measured for the single-crystal spherical carbon nanoparticles produced in Examples and for the polycrystalline carbon nanoparticles produced in Comparative Examples are referred to as the IR spectrum.

(Confirmation of generation of anion of condensed aromatic compound)

The case of naphthalene will be explained as an example of a condensed aromatic compound. Metal lithium was added to a tetrahydrofuran (THF) solution in which naphthalene was dissolved to generate a naphthalene anion, which are reduction species, and the generation was confirmed by IR absorption spectroscopy. The measurement sample was prepared by dropping the reduction liquid onto a potassium bromide (KBr) plate in a glove box under an argon atmosphere, covering the dropped solution with another KBr plate, and holding it with MagHoldIR (Jusco Engineering, Co., Ltd.). Then, it was taken out of the glove box under an argon atmosphere. This sample was measured by a transmission method using a Fourier transform infrared spectrophotometer FT/IR-6600 (JASCO Corporation). The measurement condition was a resolution of 4.0 cm$^{-1}$ and an integration count of 8 times.

(Fluorescence spectrum)

The fluorescence spectrum of the single-crystal spherical carbon nanoparticles was measured using the spectrofluorometer FT-6500 (JASCO Corporation). The above sample liquid dispersed in THF was used as a sample. The sample was placed in a quartz cell (optical path length: 1 cm) in a glove box under an argon atmosphere, the upper part was sealed, and then it was removed from the glove box and measured. The measurement condition was: the excitation bandwidth of 3 nm, fluorescence bandwidth of 3 nm, response of 0.1 seconds, scan rate of 100 nm/min, and data acquisition interval of 0.5 nm. Similarly, the fluorescence spectrum of 9,10-diphenylanthracene as a reference substance for relative fluorescence quantum efficiency was also measured under the same condition.

(Waveform separation of fluorescence spectrum)

The measured fluorescence spectrum of the single-crystal spherical carbon nanoparticles was waveform separated to calculate the relative fluorescence quantum efficiency to the fluorescence quantum efficiency of 9,10-diphenylanthracene, and the area percentage of the fluorescence spectrum with a peak at 430 nm was calculated. The waveform separation was performed using the built-in waveform separation software of FT/IR-6600, which was used for the IR absorption spectrum measurement.

(Relative Fluorescence Quantum Efficiency)

The fluorescence quantum efficiency of a fluorescent substance can be evaluated by the efficiency of fluorescence generated in response to excitation light. In the present invention, the fluorescence quantum efficiency of the single-crystal spherical carbon nanoparticles was calculated as a relative value obtained by setting the fluorescence quantum efficiency of 9,10-diphenylanthracene as a reference substance as 1.0. The relative fluorescence quantum efficiency was calculated by the following equation (1):

$$\Phi_x = \Phi_s \, (F_x/F_s)(A_s/A_x)(I_s/I_x)(n_x^2/n_s^2) \quad \cdots \quad (1)$$

In the equation, x represents the single-crystal spherical carbon nanoparticles. s represents 9,10-diphenylanthracene. $\Phi_x$ represents the relative fluorescence quantum efficiency of the single-crystal spherical carbon nanoparticles. $\Phi_s$ represents the quantum efficiency of 9,10-diphenylanthracene. F represents the area of the fluorescence spectrum. A represents the absorbance at the excitation wavelength. I represents the intensity of the excitation light. n represents the refractive index of a solvent used.

According to the present invention, for 9,10-diphenylanthracene, a reference material, and the single-crystal spherical carbon nanoparticles, the measurement condition of the spectrophotometer for measuring fluorescence, i.e., the bandpass width of excitation light, bandpass width of fluorescence, scan rate, data acquisition interval, and measurement sensitivity are all constant, and the same solvent, THF, was used. Hence, $(I_s/I_x) (n_x^2/n_s^2)$ in the equation (1) is 1.0. Therefore, the efficiencies were calculated based on the area of the fluorescence spectrum and the absorbance value at the time of measurement, of the THF dispersion of the single-crystal spherical carbon nanoparticles and the THF solution of 9,10-diphenylanthracene.

(Ultraviolet-visible: UV-vis absorption spectrum measurement)

The UV-vis (ultraviolet-visible) absorption spectrum of the single-crystal spherical carbon nanoparticles was measured using an ultraviolet-visible near-infrared spectrophotometer (V-770, JASCO Corporation). The measurement range was 200 nm to 900 nm, the sampling rate was 0.2 nm, and the measurement speed was low. A quartz liquid cell with a thickness of 10 mm was used for measurement. To calculate the relative fluorescence quantum efficiency of the single-crystal spherical carbon nanoparticles, they were diluted with THF such that the absorbance at wavelengths from 300 nm to 400 nm was 0.05 or less, and measurement was performed. The absorbance of the THF solution of 9,10-diphenylanthracene was measured under the same measurement condition.

(Circularity)

Circularity was calculated as an index for evaluating the sphericity of the single-crystal spherical carbon nanoparticles as follows. For the circularity of the single-crystal spherical carbon nanoparticles, the image obtained by TEM observation was approximated to ellipse by using the software iTEM for TEM image (Olympus Soft Imaging Solutions, GmbH). Next, the major axis (D), perimeter (Z) and area (S) of the ellipse obtained from the projected image of the single-crystal spherical carbon nanoparticles, were determined from the analysis results of the TEM image analysis software. By using the values of the perimeter (Z) and the area (S), $4\pi S/Z^2$ was calculated to obtain the circularity. As the circularity value is closer to 1, the particle is closer to a spherical shape. When the shape of the particle is truly spherical, the circularity is maximum 1.

In addition, an average value of the major axis (D) of the ellipse was determined and defined as the average particle diameter. The measurements were calculated for 50 independent single-crystal spherical arbon nanoparticles.

(X-ray diffraction: XRD)

For X-ray diffraction (XRD) measurement, a powder X-ray diffraction measurement device EMPYREAN (Spectris Corporation, Malvern Panalytical Division) was used. The measurement condition was: measurement range: 10 to 100 [$°2\theta$], Cu anticathode, tube voltage 45 kV, tube current 40 mA, and scanning speed 0.013°/min.

(Raman scattering spectrum measurement)

The Raman scattering spectrum of the single-crystal spherical carbon nanoparticles was measured using a PR-1w palmtop Raman spectrophotometer (JASCO Corporation). The wavelength of the excitation laser light was 785 nm, the output of the laser light was 5 mW, 3 cm$^{-1}$/pixel, and the measurement wavenumber was 200 cm$^{-1}$ to 3000 cm$^{-1}$.

<u>Example 1</u>

In Example 1, single-crystal spherical carbon nanoparticles were produced by reducing a THF solution of carbon tetrachloride ($CCl_4$) as a raw material (single-crystal spherical carbon nanoparticle raw material liquid), with a naphthalene-dissolved THF solution of metal lithium (single-crystal spherical carbon nanoparticle reduction liquid).

Table 1 shows the formulations of Example 1-1 to Example 1-4.

[Table 1]

| | First fluid (Liquid A) (Single-crystal spherical carbon nanoparticle reduction liquid) | | | | Second fluid (Liquid B) (Single-crystal spherical carbon nanoparticle raw material liquid) | |
|---|---|---|---|---|---|---|
| | Raw material | [mol/L] | Raw material | [mol/L] | Raw material | [mol/L] |
| Example 1-1 to Example 1-4 | Li | 0.4 | $C_{10}H_8$ | 0.4 | $CCl_4$ | 0.1 |

The solvent used in Example 1 is super dehydrated tetrahydrofuran with residual water of 10 ppm or less (FUJIFILM Wako Pure Chemical Corporation). A single-crystal spherical carbon nanoparticle reduction liquid (Liquid A) and a single-crystal spherical carbon nanoparticle raw material liquid (Liquid B) were prepared in a glove box under an argon atmosphere. Specifically, the single-crystal spherical carbon nanoparticle reduction liquid (Liquid A) was prepared at a preparation temperature of -5°C by dissolving metal lithium in a THF solution in which naphthalene had been dissolved at a concentration of 0.4 mol/L with a glass-coated magnetic stirrer such that the concentration of metal lithium became 0.4 mol/L. Similarly, carbon tetrachloride which was a single-crystal spherical carbon nanoparticle raw material of Liquid B, was dissolved in THF, and then stirred for at least 60 minutes with a glass-coated magnetic stirrer. Regarding the substances indicated by chemical formulas or abbreviations in Table 1, $CCl_4$ is carbon tetrachloride (Kanto Chemical Co., Ltd.), Li is metal lithium (Kishida Chemical Co., Ltd.), and $C_{10}H_8$ is naphthalene (Kanto Chemical Co., Ltd.).

The generation of naphthalene anion in Liquid A is confirmed by IR absorption spectrum.

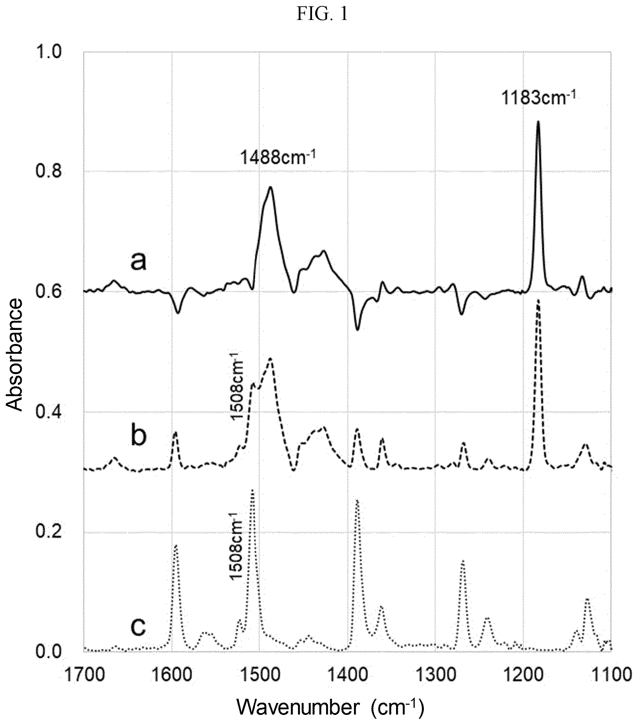

FIG. 1c shows the result of subtracting the IR absorption spectrum of THF from the IR absorption spectrum of a THF solution in which only naphthalene was dissolved. FIG. 1b shows the result of subtracting the IR absorption spectrum of the solvent THF from the IR absorption spectrum of the naphthalene THF solution in which metal lithium is dissolved. FIG. 1a is the result of adjusting the intensity of the IR absorption spectrum of FIG. 1c so that the intensity of the IR absorption spectrum of 1508cm$^{-1}$ of FIG. 1c matches the absorbance of 1508cm$^{-1}$ of FIG. 1b, and subtracting the IR absorption spectrum in FIG. 1c from the IR absorption spectrum in FIG. 1b. The peaks at 1488 cm$^{-1}$ and 1183 cm$^{-1}$ observed in FIG. 1a indicate that a naphthalene anion was generated by the transfer of an electron generated by dissolving metal lithium to the LUMO of naphthalene.

The particle diameter of the produced single-crystal spherical carbon nanoparticles is distributed by changing the reduction power of the Liquid A. Therefore, it is preferable to check the reduction power. In particular, the absorption peak of 1183cm$^{-1}$ is steep and can be measured as a single peak, so the reduction power can be clearly determined by the decrease in the intensity of this absorption peak. It is confirmed that as the reduction power decreases, the intensity of this absorption peak decreases significantly.

It was confirmed that when biphenyl or anthracene was used as a condensed aromatic compound, the anion of biphenyl or anthracene in Liquid A had 1160 cm$^{-1}$ or 1175 cm$^{-1}$ respectively. Decrease of the reduction power of these condensed aromatic compounds is also determined by the intensity of their respective absorption peaks.

Next, using the fluid processing apparatus described in Patent Literature 6 by the applicant of the present application, the prepared single-crystal spherical carbon nanoparticle reduction liquid (Liquid A) and the single-crystal spherical carbon nanoparticle raw material liquid (Liquid B) were mixed. Here, the fluid processing apparatus described in Patent Literature 6 is the apparatus described in FIG. 1(A) of Patent Literature 6, in which the opening of the second introduction part d2 has a concentric annular shape which is surrounding the central opening of the processing surface 2 which is a ring-shaped disc. Specifically, the prepared single-crystal spherical carbon nanoparticle reduction liquid (Liquid A) or the single-crystal spherical carbon nanoparticle raw material liquid (Liquid B) was introduced from the first introduction part d1 into the space between the processing surfaces 1 and 2. While the processing part 10 was rotated at several 500 rpm to 5000 rpm, another liquid different from the liquid sent above of the single-crystal spherical carbon nanoparticle raw material liquid (Liquid B) or the single-crystal spherical carbon nanoparticle reduction liquid (Liquid A) was introduced from the second introduction part d2 into the space between the processing surfaces 1 and 2. The single-crystal spherical carbon nanoparticle raw material liquid (Liquid B) and the single-crystal spherical carbon nanoparticle reduction liquid (Liquid A) were mixed in the thin film fluid to precipitate the single-crystal spherical carbon nanoparticles in the space between the processing surfaces 1 and 2. The discharged liquid containing the single-crystal spherical carbon nanoparticles was discharged from the space between the processing surfaces 1 and 2 of the fluid processing apparatus. The discharged single-crystal spherical carbon nanoparticle dispersion was collected into a beaker via a vessel.

Table 2 shows the operation conditions of the fluid processing apparatus in Example 1. The introduction temperature (liquid sending temperature) and introduction pressure (liquid sending pressure) of Liquid A and Liquid B shown in Table 2 were measured using a thermometer and a pressure gauge provided in the sealed introduction paths (the first introduction part d1 and the second introduction part d2) between the processing surfaces 1 and 2. The introduction temperature of Liquid A shown in Table 2 was the actual temperature of Liquid A in the first introduction part d1 under the introduction pressure. The introduction temperature of Liquid B was the actual temperature of Liquid B in the second introduction part d2 under the introduction pressure.

[Table 2]

| | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
|---|---|---|---|---|---|---|---|
| | | Liquid A | Liquid B | Liquid A | Liquid B | Liquid A | Liquid B |
| Example 1-1 | 5000 | 20 | 20 | 17 | 23 | 0.1 | 0.1 |
| Example 1-2 | 3500 | | | | | | |
| Example 1-3 | 2100 | | | | | | |
| Example 1-4 | 700 | | | | | | |

A wet cake sample was prepared from the single-crystal spherical carbon nanoparticle dispersion discharged from the fluid processing apparatus and recovered in a beaker. The preparation method was performed according to a conventional method. The discharged single-crystal spherical carbon nanoparticle dispersion was recovered, the single-crystal spherical carbon nanoparticles were sedimented from the recovered liquid by centrifugation (30,190 G, 2 hours), and the supernatant was removed. After the removal, ultrasonic washing with THF and sedimentation were repeated, and the finally obtained single-crystal spherical carbon nanoparticles were dried at -0.10 MPaG at 25°C for 20 hours to obtain a dry powder sample.

FIG. 2 shows a TEM image of the single-crystal spherical carbon nanoparticles of Example 1-1. Similar results were confirmed for the single-crystal spherical carbon nanoparticles of Examples 1-2 to 1-4. Since lattice fringes were observed in one direction, it was confirmed that it was a single-crystal.

(C-H Bond)

FIG. 3 shows an IR spectrum of the single-crystal spherical carbon nanoparticles of Example 1-2 at the wavenumber range of 2700 $cm^{-1}$ to 3050 $cm^{-1}$. Since the absorption peaks at 2855 $cm^{-1}$ and 2920 $cm^{-1}$ are attributed to stretching vibrations of C-H bond, it was confirmed that the single-crystal spherical carbon nanoparticles are hydrogenated. The same confirmation was made for Examples 1-1, 1-3, and 1-4.

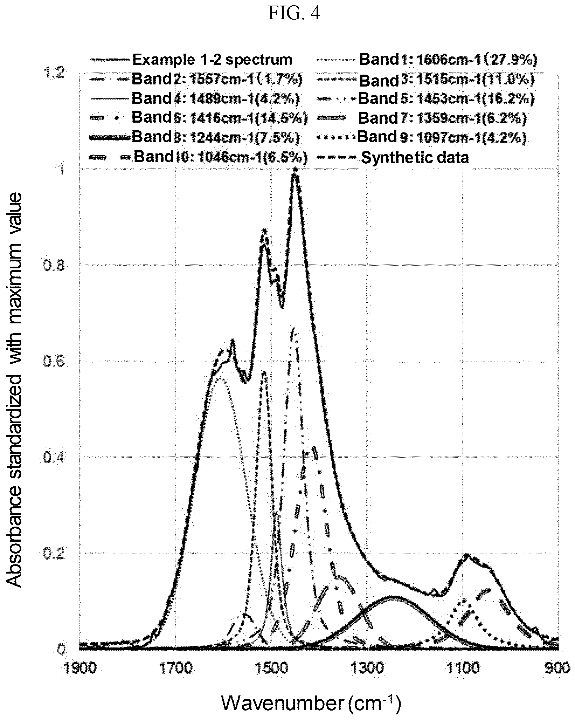

FIG. 4 shows results of waveform separation of the IR spectrum measurement results of the single-crystal spherical carbon nanoparticles of Example 1-2 at the wavenumbers 900 $cm^{-1}$ to 1900 $cm^{-1}$. The peak wavenumber of each band after waveform separation and the relative area ratio in parentheses are shown. Waveform separation was performed using waveform separation software built into FT/IR-6600.

(C-O bond)

The IR spectrum of FIG. 4 is divided into ten parts by waveform separation, and the absorption in the wavenumber range of 1000 $cm^{-1}$ to 1100 $cm^{-1}$ is attributed to the C-O bond. The ratio of Band 9 and Band 10, which were waveform separated in this wavenumber range, to the total area (ratio of C-O bond) was 10.7%. The ratio of C-O bond is preferably 2% or more and 15% or less. When the ratio is less than 2%, it will be difficult to disperse the single-crystal spherical carbon nanoparticles in an aqueous solution. When the ratio exceeds 15%, there is an inconvenience that the circularity of the single-crystal spheric carbon nanoparticles becomes 0.9 or less, and then the distance between two nanoparticles increases compared with the spherical shape, causing decrease of the relative fluorescence quantum efficiency.

The C-O bonds of the single-crystal spherical carbon nanoparticles are formed by controlling the water content to always be 10 ppm or less, when the single-crystal spherical carbon nanoparticles are produced by a reduction reaction in ultra-dehydrated THF which is a grade specified with residual water of 10 ppm or less in tetrahydrofuran (THF). Because the graphene layer is reactive immediately after the reduction reaction, the single-crystal spherical carbon nanoparticles can be protected by a mild oxidation reaction caused by a certain amount of water. By protecting the surface of the single-crystal spherical carbon nanoparticles in this manner, variations due to oxidation during cleaning and recovery process can be suppressed. This washing and recovery basically requires dissolving the residual organic substances once in a THF solvent and then washing with pure water, but some oxidation reaction progresses during this washing and recovery process.

(C-N bond)

The C-N bond is generated by reacting oxygen with the top surface of the graphene layer that was not protected due to exposure to the air atmosphere during the cleaning and recovery process of the single-crystal spherical carbon nanoparticles. Since no nitrogen-containing raw materials or solvents are used in the reduction reaction of the single-crystal spherical carbon nanoparticles, the C-N bond is generated after the reaction of the single-crystal spherical carbon nanoparticles. Therefore, nitrogen does not have a significant effect on the fluorescent properties of the single-crystal spherical carbon nanoparticles, but it is also possible to terminate the defect by nitrogen. The C-N bond has absorption in the wavenumber range of 1300 $cm^{-1}$ to 1400 $cm^{-1}$, so in the IR spectrum of FIG. 4, the C-N bond corresponds to Band 7 with a peak wavenumber of 1357 $cm^{-1}$, and the relative area ratio (ratio of C-N bond) is 6.2%. Since the C-N bond together with the C-O bond, has the effect of terminating the defect where the bond of carbon atoms in the graphene layer are broken, the ratio of C-N bond is preferably 10% or less. This C-N bond may not be detectable in case where the C-O bond terminates the carbon atom bond defect.

Since the C-H bond in the single-crystal spherical carbon nanoparticles confirmed in FIG. 3 can make the surface of the single-crystal spherical carbon nanoparticles hydrophobic, the single-crystal spherical carbon nanoparticles can be well dispersed in an organic solvent. However, according to the results shown in FIG. 4, it was confirmed that dispersibility in an aqueous solvent was also possible due to coexistence of the C-O bond.

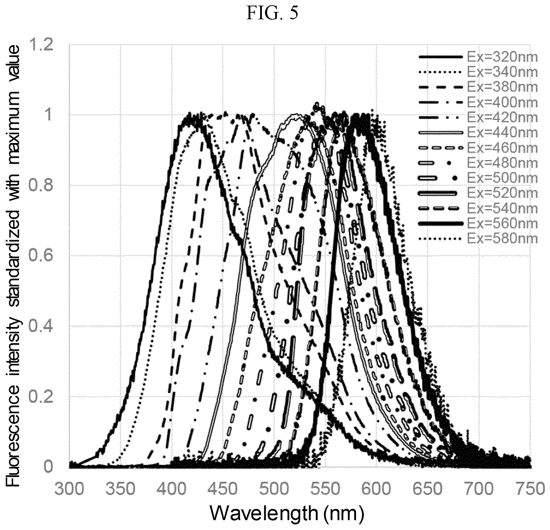

FIG. 5 shows a fluorescence spectrum of the single-crystal spherical carbon nanoparticles of Examples 1-3. The fluorescence spectrum is the fluorescence spectrum normalized by setting the maximum intensity of the fluorescence spectrum obtained for each excitation wavelength to 1.0, and is the result of changing the excitation wavelength every 20 nm from 320 nm to 580 nm. From the results shown in FIG. 5, it was confirmed that the fluorescence of the single-crystal spherical carbon nanoparticles of Example 1-3 showed a maximum peak at 400 nm to 600 nm, depending on the excitation wavelength.

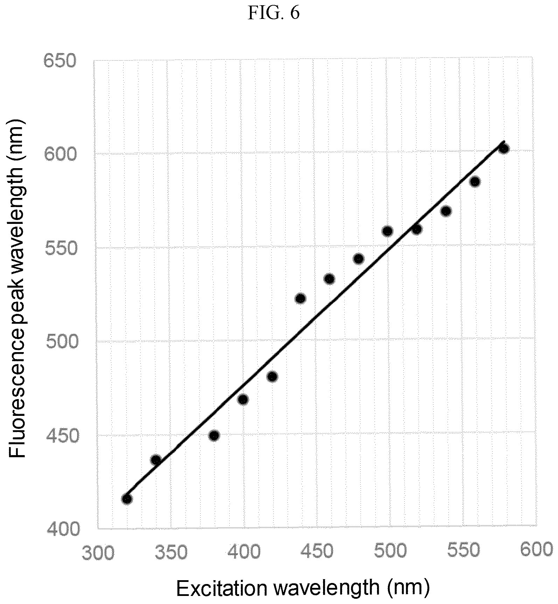

FIG. 6 shows a diagram showing the relationship between excitation wavelength and fluorescence peak wavelength, prepared based on the results of FIG. 5. FIG. 6 indicates dependency of excitation wavelength to fluorescence peak wavelength of the single-crystal spherical carbon nanoparticles of Example 1-3. It is known that as the particle diameter of the single-crystal spherical carbon nanoparticles increases, the fluorescence peak wavelength shifts to the longer wavelength side. It is determined that fluorescence from the single-crystal spherical nanoparticles which particle diameter increases little by little, is obtained.

This change in the fluorescence peak wavelength in the single-crystal spherical carbon nanoparticles is explained by (A) quantum effect mechanism among the above-mentioned three mechanisms (A) to (C). That is, the fluorescence peak wavelength of the single-crystal spherical carbon nanoparticles is thought to be shifted to the shorter wavelength side because the band gap increases as the particle diameter of the single-crystal spherical carbon nanoparticles decreases. This is a result due to (A) the quantum effect mechanism. Furthermore, the single-crystal spherical carbon nanoparticles of the present invention are not surface-modified with alkyl groups, amino groups, etc., and do not have (B) the surface modification mechanism among the above-mentioned three mechanisms. It is thought that the fluorescence is produced by a synergistic effect of (C) an oxygen-mediated mechanism due to the bonding of oxygen to the particles and (A) a quantum effect mechanism.

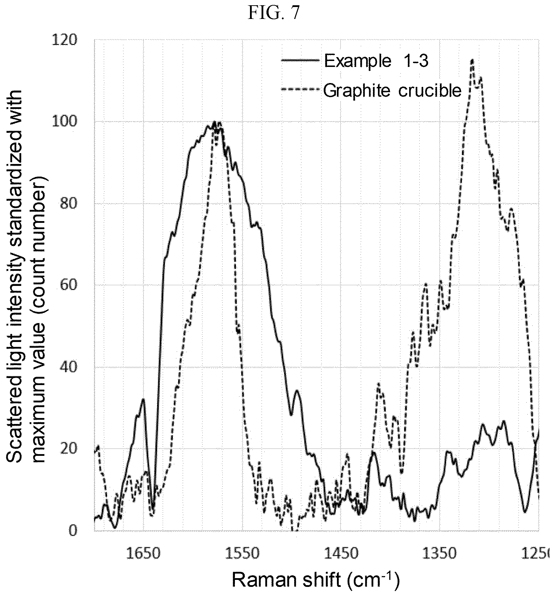

FIG. 7 shows a Raman scattering spectrum of the single-crystal spherical carbon nanoparticles produced in Example 1-3. The Raman scattering spectrum of nanoparticles obtained by crushing a graphite crucible in a mortar is shown for comparison. The Raman scattering spectrum of graphite shows a peak called $I_G$ Band only in the wavenumber range of 1650cm$^{-1}$ to 1550cm$^{-1}$, but if the bonding of the graphene layer is disrupted and defects occur in graphite, the peak called $I_D$ Band appears in the wavenumber range of 1300cm$^{-1}$ to 1450cm$^{-1}$. Accordingly, defects in the carbon material can be estimated based on the value of $I_D/I_G$, which is the spectral intensity ratio of the two. FIG. 6 shows the results of a relative comparison of the intensity of the $I_D$ Band with the intensity of the $I_G$ Band of each carbon particle as 100. The value of $I_D/I_G$ of the single-crystal spherical carbon nanoparticles manufactured in Example 1-3 was 0.23, and it was confirmed that there were few bonding defects.

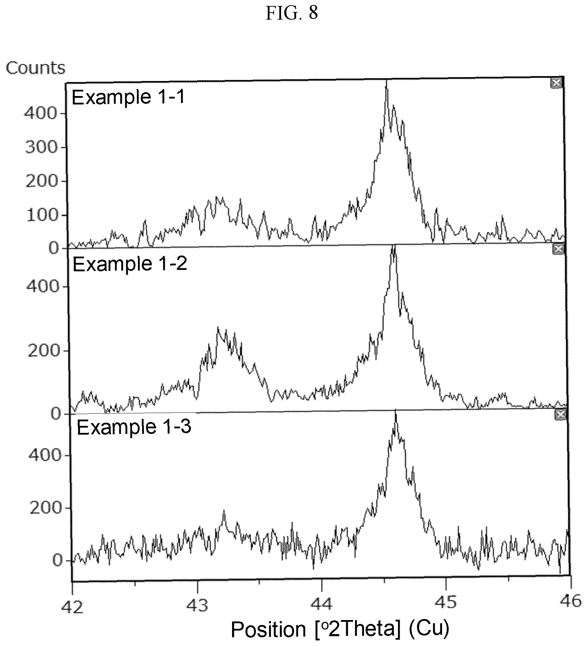

FIG. 8 shows X-ray diffraction patterns of the single-crystal spherical carbon nanoparticles produced in Examples 1-1 to 1-3. Graphite crystal has a structure in which graphene layers in which C=C bonds formed by carbon atoms with sp2 hybrid orbital form a planar layer are stacked in the c-axis direction. Graphite with hexagonal crystals as a crystal form can form a simple lattice and a rhombohedral lattice as a space lattice. The peaks at diffraction angles $2\theta$ of 42.2° and 44.6° appear due to a simple lattice of hexagonal structure, whereas the peak at $2\theta$ of 43.3° appear due to a rhombohedral lattice. This result shows that when the single-crystal spherical carbon nanoparticles with a hexagonal crystal structure have a simple lattice as a space lattice, if the two graphene layers are A layer and B layer, they have a stacked structure like ABABAB..., and when the single-crystal spherical carbon nanoparticles with a hexagonal crystal structure have a rhombohedral lattice, if the three graphene layers are layer A, layer B, and layer C, they have a stacked structure like ABCABCABC... The average lattice spacing was calculated as follows. At first, the sum of two values of the lattice spacing calculated by Bragg's formula from the diffraction peak angles confirmed near the diffraction angles $2\theta$ = 44.6° and $2\theta$ = 43.3° was divided by 2 to obtain an arithmetic mean value. Then, this arithmetic mean value was measured for 10 samples, and the sum of these values was divided by 10 to calculate the average lattice spacing.

Table 3 shows the average particle diameter, average circularity, crystal structure, average lattice spacing of the graphene layer, the ratio of C-O bond obtained by the IR spectrum, the $I_D/I_G$ ratio obtained by the Raman scattering spectrum, and the relative fluorescence quantum efficiency of the single-crystal spherical carbon nanoparticles are shown.

[Table 3]

| | Average particle diameter [nm] | Average circularity | Spatial lattice | Average lattice spacing [pm] | IR ratio of C-O bond [%] | Raman $I_D / I_G$ | Relative fluoresence quantum effeciency [%] |
|---|---|---|---|---|---|---|---|
| Example 1-1 | 5.2 | 0.94 | simple & rhombohedral | 203 | 6.3 | 0.23 | 15 |
| Example 1-2 | 6.2 | 0.93 | simple & rhombohedral | 204 | 7.2 | 0.42 | 14 |
| Example 1-3 | 7.6 | 0.93 | simple & rhombohedral | 204 | 7.9 | 0.83 | 14 |
| Example 1-4 | 8.1 | 0.91 | simple & rhombohedral | 205 | 8.5 | 1.0 | 12 |

Comparative Example 1

The formulation of Comparative Example 1 was the same as that of Example 1 shown in Table 1, but as shown in Table 4, the disk rotation speed was lowered to 600 rpm or 500 rpm to produce single-crystal spherical carbon nanoparticles. Table 5 shows the results of the single-crystal spherical carbon nanoparticles obtained. By reducing the disk rotation speed to less than 700 rpm, no change was observed in the crystal structure, but the average circularity became less than 0.9 and the $I_D/I_G$ ratio increased from 1.0, causing increased defects compared to Example 1, and thus, the relative fluorescence quantum efficiency became a low value of 5% or less.

[Table 4]

| | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
| --- | --- | --- | --- | --- | --- | --- | --- |
| | | Liquid A | Liquid B | Liquid A | Liquid B | Liquid A | Liquid B |
| Comparative Example 1-1 | 600 | 20 | 20 | 17 | 23 | 0.1 | 0.1 |
| Comparative Example 1-2 | 500 | | | | | | |

[Table 5]

| | Average particle diameter [nm] | Average circularity | Spatial lattice | Average lattice spacing [pm] | IR ratio of C-O bond [%] | Raman $I_D / I_G$ | Relative fluoresence quantum effeciency [%] |
| --- | --- | --- | --- | --- | --- | --- | --- |
| Comparative Example 1-1 | 10.2 | 0.87 | simple & rhombohedral | 205 | 10.2 | 1.35 | 3 |
| Comparative Example 1-2 | 11.2 | 0.85 | simple & rhombohedral | 206 | 11.5 | 1.67 | 3 |

Example 2

Example 2 shows the results of the production of the single-crystal spherical carbon nanoparticles wherein the temperature of the single-crystal spherical carbon particle reduction liquid was -10°C (below 0°C) and 10°C, and the disk rotation speed was 5000 rpm and 3500 rpm. The formulations of the single-crystal spherical carbon nanoparticle reduction liquid and the single-crystal spherical carbon nanoparticle raw material liquid were the same as in Example 1, and were prepared under the conditions shown in Table 1. Table 6 shows the manufacturing conditions of Example 2, and the results of the obtained single-crystal spherical carbon nanoparticles are as shown in Table 7. In the single-crystal spherical carbon nanoparticles produced in Example 2, the lower the temperature of the single-crystal spherical carbon nanoparticle reduction solution (Liquid A), the smaller the average particle diameter, but the relative fluorescence quantum efficiency was 10% or more.

[Table 6]

| | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
| --- | --- | --- | --- | --- | --- | --- | --- |
| | | Liquid A | Liquid B | Liquid A | Liquid B | Liquid A | Liquid B |
| Example 2-1 | 5000 | 20 | 20 | -10 | 23 | 0.1 | 0.1 |
| Example 2-2 | 3500 | | | | | | |
| Example 2-3 | 5000 | | | 10 | | | |
| Example 2-4 | 3500 | | | | | | |

[Table 7]

| | Average particle diameter [nm] | Average circularity | Spatial lattice | Average lattice spacing [pm] | IR ratio of C-O bond [%] | Raman $I_D / I_G$ | Relative fluoresence quantum effeciency [%] |
| --- | --- | --- | --- | --- | --- | --- | --- |
| Example 2-1 | 4.2 | 0.94 | simple & rhombohedral | 203 | 6.9 | 0.56 | 10 |

(continued)

|  | Average particle diameter [nm] | Average circularity | Spatial lattice | Average lattice spacing [pm] | IR ratio of C-O bond [%] | Raman $I_D / I_G$ | Relative fluoresence quantum effeciency [%] |
|---|---|---|---|---|---|---|---|
| Example 2-2 | 5.5 | 0.93 | simple & rhombohedral | 205 | 8.4 | 0.94 | 10 |
| Example 2-3 | 4.9 | 0.95 | simple & rhombohedral | 205 | 6.2 | 0.22 | 14 |
| Example 2-4 | 6.2 | 0.94 | simple & rhombohedral | 206 | 7.5 | 0.50 | 12 |

Comparative Example 2

The formulation of Comparative Example 2 was the same as that of Example 1 shown in Table 1, but as shown in Table 8, the disk rotation speed was lowered to 700 rpm, and the temperatures of the single-crystal spherical carbon nanoparticle reduction liquid (Liquid A) was -10°C and 10°C, to produce single-crystal spherical carbon nanoparticles. Table 9 shows the results of the single-crystal spherical carbon nanoparticles obtained. By reducing the disk rotation speed to 700 rpm, and setting the temperature of Liquid A to be 10°C or less, the average circularity the single-crystal spherical carbon nanoparticles became less than 0.9 and the $I_D / I_G$ ratio which indicating the abundance ratio of defects calculated by the Raman scattering spectrum increased to be 1.0 or more, and thus, the relative fluorescence quantum efficiency became a low value of 5% or less.

[Table 8]

|  | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
|---|---|---|---|---|---|---|---|
|  |  | Liquid A | Liquid B | Liquid A | Liquid B | Liquid A | Liquid B |
| Comparative Example 2-1 | 700 | 20 | 20 | -10 | 23 | 0.1 | 0.1 |
| Comparative Example 2-2 | 700 | | | 10 | | | |

[Table 9]

|  | Average particle diameter [nm] | Average circularity | Spatial lattice | Average lattice spacing [pm] | IR ratio of C-O bond [%] | Raman $I_D / I_G$ | Relative fluoresence quantum effeciency [%] |
|---|---|---|---|---|---|---|---|
| Comparative Example 2-1 | 6.8 | 0.88 | simple & rhombohedral | 206 | 6.9 | 1.48 | 2 |
| Comparative Example 2-2 | 7.2 | 0.89 | simple & rhombohedral | 206 | 8.4 | 1.25 | 4 |

Example 3

In Example 3, the single-crystal spherical carbon nanoparticles were produced, wherein the formulations of Liquid A and Liquid B were the same as those in Table 1, and the flow rate ratio of the single-crystal spherical carbon particle raw material liquid (Liquid B) to the single-crystal spherical carbon particle reduction liquid (Liquid A) were changed. Table 10 shows the manufacturing conditions of the single-crystal spherical carbon nanoparticles. Table 11 shows the results for the obtained single-crystal spherical carbon nanoparticles.

[Table 10]

|  | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
|---|---|---|---|---|---|---|---|
|  |  | Liquid A | Liquid B | Liquid A | Liquid B | Liquid A | Liquid B |
| Example 3-1 | 5000 | 40 | 40 | 17 | 23 | 0.1 | 0.1 |
| Example 3-2 |  |  | 20 |  |  |  |  |
| Example 3-3 |  |  | 10 |  |  |  |  |

[Table 11]

|  | Average particle diameter [nm] | Average circularity | Spatial lattice | Average lattice spacing [pm] | IR ratio of C-O bond [%] | Raman $I_D / I_G$ | Relative fluoresence quantum effeciency [%] |
|---|---|---|---|---|---|---|---|
| Example 3-1 | 5.2 | 0.94 | simple & rhombohedral | 209 | 5.2 | 0.32 | 15 |
| Example 3-2 | 5.0 | 0.93 | rhombohedral | 209 | 4.6 | 0.95 | 15 |
| Example 3-3 | 4.8 | 0.93 | rhombohedral | 210 | 4.3 | 1.0 | 17 |

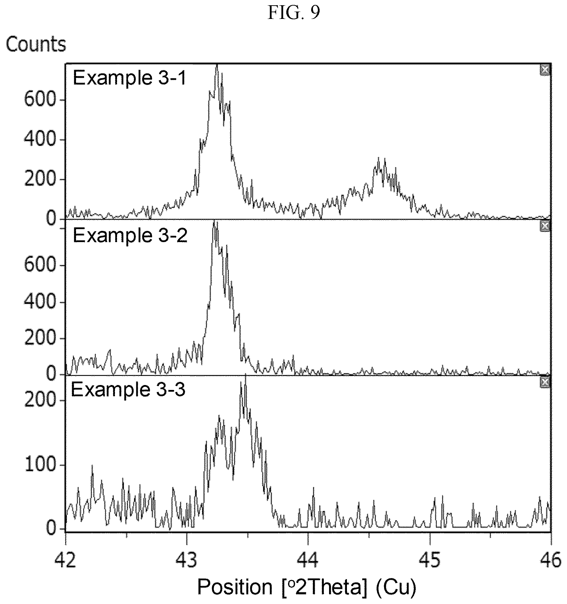

FIG. 9 shows X-ray diffraction patterns of the single-crystal spherical carbon nanoparticles produced in Examples 3-1 to 3-3. In Example 3-1, a diffraction peak with a diffraction angle 2θ of 43.25° due to the hexagonal and rhombohedral space lattice and a diffraction peak at 44.6° due to the hexagonal and simple lattice are observed. In Example 3-2 and Example 3-3, a diffraction peak with a diffraction angle 2θ of 43.25° due to the rhombohedral space lattice was observed, and the results suggested that most of nanoparticles have a rhombohedral space lattice. In Example 3-3, a peak at 43.5° was also seen, but it was determined to be due to the rhombohedral lattice.

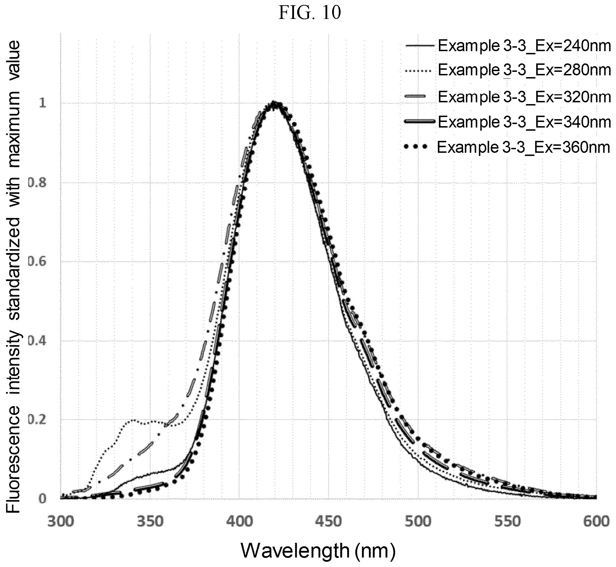

FIG. 10 shows a fluorescence spectrum of the single-crystal spherical carbon nanoparticles produced in Example 3-3. The fluorescence peak wavelength measured at an excitation wavelength of 240 nm to 360 nm was 420 nm, indicating no dependency of excitation wavelength. The fluorescence peak wavelength of Examples 1-3 shown in FIG. 4 shows dependency of excitation wavelength, and as the excitation wavelength becomes longer, the fluorescence peak wavelength also shifts to the longer wavelength side. The structure of the single-crystal spherical carbon nanoparticles corresponds to a hexagonal structure in which a simple lattice and a rhombohedral lattice coexist, as shown in FIG. 7. In Example 3-3, results shows existence of only the rhombohedral lattice, so it is considered that the difference in the dependency of excitation wavelength to the fluorescence peak wavelength is due to the difference in the spatial lattice of the single-crystal spherical carbon nanoparticles.

In the production of the single-crystal spherical carbon nanoparticles, the effect of increasing the flow rate of the single-crystal spherical carbon nanoparticle reduction liquid (Liquid A) compared to the flow rate of the single-crystal spherical carbon nanoparticle raw material liquid (Liquid B) is that the reduction reaction rate is increased, a large number of fine graphene layers are produced, and these fine graphene layers are stacked together in the c-axis direction, thereby smaller single-crystal spherical carbon nanoparticles can be produced. In this way, by increasing the flow rate of the single-crystal spherical carbon nanoparticle reduction liquid (Liquid A) compared to the flow rate of the single-crystal spherical carbon nanoparticle raw material liquid (Liquid B), the symmetry of the fluorescence spectrum is improved, and fluorescence with a narrow fluorescence spectrum half-width of 70 nm and high color purity can be obtained.

INDUSTRIAL APPLICABILITY

The production method of the present invention enables to produce the single-crystal spherical carbon nanoparticles that are single-crystals and spherical. The produced single-crystal spherical carbon nanoparticles are single-crystals without grain boundaries that reduce fluorescence efficiency, so that they can generate fluorescence with high fluorescence quantum efficiency when excited by a light in a wide wavelength range from ultraviolet light to visible light, and have a fluorescence quantum efficiency of 10% or more compared to conventionally known carbon nanoparticles. In addition, the single-crystal spherical carbon nanoparticles of the present invention can be used for drug delivery, because they do not have toxicities to living organisms that compound semiconductors made of cadmium, selenium, tellurium, etc. have. Furthermore, since the single-crystal spherical carbon nanoparticles produced by the production method of the present invention are spherical, they can be densely packed as electrode materials for solar cells and secondary ion batteries, and can be used for a negative electrode for lithium batteries or an electrode material for solar cells.

**Claims**

1. A method of producing single-crystal spherical carbon nanoparticles that are single-crystals and spherical, comprising a step of mixing and reacting a raw material liquid containing halogenated carbon and a reduction liquid containing an anion of a condensed aromatic compound produced from lithium, sodium or potassium and the condensed aromatic compound,
   wherein the anion of the condensed aromatic compound is obtained by mixing lithium, sodium or potassium with the condensed aromatic compound at a temperature below 0°C.

2. The method according to claim 1, wherein an average value of a circularity calculated by the formula: $4\pi S/Z^2$ is 0.9 or more, when using the perimeter (Z) and the area (S) of the projected image of the single-crystal spherical carbon nanoparticle observed by a transmission electron microscope.

3. The method according to claim 1 or 2, wherein the average particle diameter is 1 nm to 30 nm.

4. The method according to any one of claims 1 to 3, wherein the raw material liquid and the reduction liquid are mixed and reacted with each other using an apparatus, and

   wherein the apparatus comprises a fluid pressure imparting mechanism for imparting a predetermined pressure to fluids to be processed; at least two processing members of a first processing member and a second processing member, the second processing member being capable of approaching to and separating from the first processing member; and a rotation drive mechanism for rotating the first processing member and the second processing member relative to each other; and
   wherein the at least two processing members provide at least two processing surfaces of a first processing surface and a second processing surface disposed in a position facing with each other,
   each of the processing surfaces constitute part of a sealed flow path through which the fluid to be processed under the predetermined pressure is passed,
   the processing surfaces are for mixing and reacting two or more fluids to be processed, at least one of which contains a reactant, with each other,
   of the first and second processing members, at least the second processing member is provided with a pressure-receiving surface, and at least part of the pressure-receiving surface is comprised of the second processing surface,
   the pressure-receiving surface receives pressure applied to the fluids to be processed by the fluid pressure imparting mechanism and thereby generates a force to move in the direction of separating the second processing surface from the first processing surface,
   the fluids to be processed under the predetermined pressure are passed between the first and second processing surfaces being capable of approaching to and separating from each other, at least one of which rotates relative to the other, whereby the fluids to be processed form a thin film fluid while passing between the first and second processing surfaces,
   the apparatus further comprises an introduction path independent of the flow paths through which the fluids to be processed under the predetermined pressure are passed; and at least one opening leading to the introduction path and being arranged in at least either the first processing surface or the second processing surface, and at least one of the fluids to be processed is sent from the introduction path and introduced into between the first and second processing surfaces, and a reactant contained at least in any one of the aforementioned fluids to be processed is mixed with the fluids to be processed other than the fluid containing the reactant in the thin film fluid.

5. The method according to claim 4, wherein the opening is located downstream of a point at which the flow of the fluids to be processed that is passed between the two processing surfaces becomes a laminar flow.

6. The method according to any one of claims 1 to 5, wherein the molar ratio of the lithium, sodium or potassium and the halogenated carbon is 7:1 to 4:1.

7. The method according to any one of claims 1 to 6, wherein the condensed aromatic compound is at least one selected from the group consisting of biphenyl, naphthalene, 1,2-dihydronaphthalene, anthracene, phenanthrene and pyrene.

8. The method according to claim 7, wherein when the condensed aromatic compound is biphenyl, naphthalene or anthracene, an IR absorption spectrum of the reduction liquid shows an absorption peak in the wave number range of 1200 $cm^{-1}$ to 1100 $cm^{-1}$.

9. The method according to any one of claims 1 to 8, wherein the solvent contained in the reduction liquid is tetrahydrofuran and/or dimethoxyethane with residual water of 10 ppm or less.

10. The method according to any one of claims 1 to 9, wherein the solvent contained in the reduction liquid is tetrahydrofuran which contains a phenolic polymerization inhibitor, and has residual water of 10 ppm or less and residual oxygen concentration of less than 0.1 ppm.

11. The method according to any one of claims 1 to 10, wherein the solvent contained in the raw material liquid is tetrahydrofuran which has residual water of 10 ppm or less and a residual oxygen concentration of less than 0.1 ppm.

12. The method according to any one of claims 1 to 11, wherein the halogenated carbon is carbon tetrachloride, carbon tetrabromide, or carbon tetraiodide.

13. The method according to any one of claims 1 to 12, wherein the single-crystal spherical carbon nanoparticles are hexagonal and the spatial lattice is a simple lattice, a rhombohedral lattice, or a combination of a simple lattice and a rhombohedral lattice.

14. The method according to any one of claims 1 to 13, wherein the single-crystal spherical carbon nanoparticles have an absorption peak in the wavenumber range of 2800 $cm^{-1}$ to 2950 $cm^{-1}$ in an IR absorption spectrum, and the area of the absorption peak of 1000 $cm^{-1}$ to 1100 $cm^{-1}$ obtained by waveform separation of the wavenumber range of 900 $cm^{-1}$ to 1900 $cm^{-1}$ is 15% or less of the total area of absorption peaks in the wavenumber range of 900 $cm^{-1}$ to 1900 $cm^{-1}$.

15. The method according to any one of claims 1 to 14, wherein in an IR absorption spectrum of the single-crystal spherical carbon nanoparticles, the area of the absorption peak of 1300 $cm^{-1}$ to 1400 $cm^{-1}$ obtained by waveform separation of the wavenumber range of 900 $cm^{-1}$ to 1900 $cm^{-1}$ is 10% or less of the total area of absorption peaks in the wavenumber range of 900 $cm^{-1}$ to 1900 $cm^{-1}$.

16. The method according to any one of claims 1 to 15, wherein in a Raman scattering spectrum of the single-crystal spherical carbon nanoparticles, the ratio of $I_n/I_G$ is 1.0 or less, wherein $I_G$ is the intensity of the peak from 1550 $cm^{-1}$ to 1650 $cm^{-1}$, and $I_D$ is the intensity of the peak from 1250 $cm^{-1}$ to 1350 $cm^{-1}$.

17. The method according to any one of claims 1 to 16, wherein the single-crystal spherical carbon nanoparticles have a fluorescence maximum in a wavelength range of 400 nm to 600 nm in a fluorescence spectrum.

FIG. 1

FIG. 2

FIG. 3

FIG. 4

FIG. 5

FIG. 6

FIG. 7

FIG. 8

FIG. 9

FIG. 10

国際調査報告

| 国際出願番号 |
|---|
| PCT/JP2022/036803 |

| A. | 発明の属する分野の分類（国際特許分類（ＩＰＣ）） |
|---|---|

C01B 32/15(2017.01)i; C09K 11/65(2006.01)i; B82Y 5/00(2011.01)n; B82Y 40/00(2011.01)n
FI: C01B32/15; C09K11/65; B82Y5/00; B82Y40/00

| B. | 調査を行った分野 |
|---|---|

調査を行った最小限資料（国際特許分類（ＩＰＣ））

C01B32/15; C09K11/65; B82Y5/00; B82Y40/00

最小限資料以外の資料で調査を行った分野に含まれるもの

日本国実用新案公報　　　　　　　１９２２－１９９６年
日本国公開実用新案公報　　　　　１９７１－２０２２年
日本国実用新案登録公報　　　　　１９９６－２０２２年
日本国登録実用新案公報　　　　　１９９４－２０２２年

国際調査で使用した電子データベース（データベースの名称、調査に使用した用語）

JSTPlus/JMEDPlus/JST7580/JSTChina (JDreamIII)

| C. | 関連すると認められる文献 |
|---|---|

| 引用文献の<br>カテゴリー* | 引用文献名　及び一部の箇所が関連するときは、その関連する箇所の表示 | 関連する<br>請求項の番号 |
|---|---|---|
| A | CN 105860968 A (TECHNICAL INST PHYSICS & CHEMISTRY, CHINESE ACADEMY OF SCIENCE) 17.08.2016 (2016 - 08 - 17)<br>　　請求項1-2,4, 実施例, 図1,3 | 1-17 |
| A | US 2019/0315626 A1 (KOREA ADVANCED INSTITUTE OF SCIENCE AND TECHNOLOGY) 17.10.2019 (2019 - 10 - 17)<br>　　Figs.2,5-6,9, [0012], [0037], [0135]-[0154] | 1-17 |
| A | CHENG, Yu, et al., Journal of Photochemistry & Photobiology, A: Chemistry, 2022.03.17, Vol.429, 113910, DOI:10.1016/j.jphotochem.2022.113910<br>　　Abstract, 2.3. Continuous synthesis system of carbon dots, 3.1. Characterization, Figs.2-4 | 1-17 |
| A | AWALLUDIN, Anis Sofia, et al., Emergent Materials, 2022.03.04, Vol.5, PP.133-143, DOI:10.1007/s42247-022-00365-z<br>　　Abstract, PP.135,137-138, Figs.1-2 | 1-17 |
| A | US 2019/0035635 A1 (SAMSUNG ELECTRONICS CO., LTD.) 31.01.2019 (2019 - 01 - 31)<br>　　Fig.4, [0047]-[0049], [0085]-[0087], [0172], [0252] | 1-17 |

☑ C欄の続きにも文献が列挙されている。　　　　　　　☑ パテントファミリーに関する別紙を参照。

＊　引用文献のカテゴリー
"A" 特に関連のある文献ではなく、一般的技術水準を示すもの
"E" 国際出願日前の出願または特許であるが、国際出願日以後に公表されたもの
"L" 優先権主張に疑義を提起する文献又は他の文献の発行日若しくは他の特別な理由を確立するために引用する文献（理由を付す）
"O" 口頭による開示、使用、展示等に言及する文献
"P" 国際出願日前で、かつ優先権の主張の基礎となる出願の日の後に公表された文献

"T" 国際出願日又は優先日後に公表された文献であって出願と抵触するものではなく、発明の原理又は理論の理解のために引用するもの
"X" 特に関連のある文献であって、当該文献のみで発明の新規性又は進歩性がないと考えられるもの
"Y" 特に関連のある文献であって、当該文献と他の１以上の文献との、当業者にとって自明である組合せによって進歩性がないと考えられるもの
"&" 同一パテントファミリー文献

| 国際調査を完了した日 | 国際調査報告の発送日 |
|---|---|
| 17.11.2022 | 06.12.2022 |

| 名称及びあて先 | 権限のある職員（特許庁審査官） |
|---|---|
| 日本国特許庁(ISA/JP)<br>〒100-8915<br>日本国<br>東京都千代田区霞が関三丁目４番３号 | 田口　裕健 4G 4663<br><br>電話番号 03-3581-1101 内線 3416 |

様式 PCT/ISA/210 （第２ページ）（２０１５年１月）

国際調査報告

| 国際出願番号 |
| --- |
| PCT/JP2022/036803 |

C.　　関連すると認められる文献

| 引用文献の<br>カテゴリー* | 引用文献名　及び一部の箇所が関連するときは、その関連する箇所の表示 | 関連する<br>請求項の番号 |
| --- | --- | --- |
| A | HIGASHI, Hidenori, et al., Journal of Chemical Engineering of Japan, 2021,<br>Vol.54, No.5, PP.266-275, DOI:10.1252/jcej.20we143<br>　　Abstract, 2. Results and Discussion, Figs.2-7 | 1-17 |
| A | WO 2009/008389 A1 (エム・テクニック株式会社) 15.01.2009 (2009 - 01 - 15)<br>　　請求項12-13 | 4-5 |

様式 PCT/ISA/210 (第2ページ) (2015年1月)

国際調査報告
パテントファミリーに関する情報

<table>
<tr><td>国際出願番号</td></tr>
<tr><td>PCT/JP2022/036803</td></tr>
</table>

| 引用文献 | 公表日 | パテントファミリー文献 | 公表日 |
|---|---|---|---|
| CN 105860968 A | 17.08.2016 | （ファミリーなし） | |
| US 2019/0315626 A1 | 17.10.2019 | KR 10-2019-0119498 A<br>KR 10-2020-0103603 A | |
| US 2019/0035635 A1 | 31.01.2019 | KR 10-2019-0012563 A | |
| WO 2009/008389 A1 | 15.01.2009 | US 2010/0196788 A1<br>Claims 12-13<br>EP 2179791 A1<br>CN 101784338 A | |

様式 PCT/ISA/210 （パテントファミリー用別紙）（２０１５年１月）

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018163955 A
- JP 2019155349 A
- JP 2021183548 A
- JP 2019511442 A
- JP 4458202 B
- JP 4363495 B
- JP 2009112892 A

**Non-patent literature cited in the description**

- *Journal of Materials Chemistry*, 2014, vol. 2, 6025-6031